(19) Europäisches Patentamt
European Patent Office
Office européen des brevets

(11) **EP 0 925 552 B1**

(12) **EUROPÄISCHE PATENTSCHRIFT**

(45) Veröffentlichungstag und Bekanntmachung des Hinweises auf die Patenterteilung:
**15.05.2002 Patentblatt 2002/20**

(21) Anmeldenummer: **97909231.9**

(22) Anmeldetag: **08.09.1997**

(51) Int Cl.[7]: **G06K 19/077**

(86) Internationale Anmeldenummer:
**PCT/EP97/04889**

(87) Internationale Veröffentlichungsnummer:
**WO 98/11506 (19.03.1998 Gazette 1998/11)**

(54) **CHIPKARTE UND VERFAHREN ZUR HERSTELLUNG EINER CHIPKARTE**

CHIP CARD AND METHOD TO PRODUCE A CHIP CARD

CARTE A PUCE ET PROCEDE DE PRODUCTION D'UNE CARTE A PUCE

(84) Benannte Vertragsstaaten:
**AT BE CH DE DK ES FI FR GB GR IE IT LI LU MC NL PT SE**

(30) Priorität: **10.09.1996 DE 19636754**
**08.10.1996 DE 19641406**

(43) Veröffentlichungstag der Anmeldung:
**30.06.1999 Patentblatt 1999/26**

(73) Patentinhaber:
• **PAV Card GmbH**
**22952 Lütjensee (DE)**
• **Centrum für Mikroverbindungstechnik in der Elektronik-Forschung und Entwicklunf GGMBH 25524 Itzehoe (DE)**

(72) Erfinder:
• **WILM, Robert**
**D-22929 Kasseburg (DE)**
• **REINERT, Wolfgang**
**D-24536 Neumünster (DE)**

(74) Vertreter: **Kruspig, Volkmar, Dipl.-Ing. et al Patentanwälte**
**Meissner, Bolte & Partner**
**Postfach 86 06 24**
**81633 München (DE)**

(56) Entgegenhaltungen:
**EP-A- 0 554 581      DE-A- 19 500 925**
**DE-A- 19 513 607**

**Beschreibung**

Die Erfindung betrifft eine Chipkarte, die einen integrierten Schaltkreis und ein Antennenelement zum berührungslosen Übertragen von Daten aufweist sowie ein Verfahren zur Herstellung einer Chipkarte.

Allgemein sind Chipkarten bekannt, bei denen Daten über auf der Chipkarte vorgesehene Kontakte eingeschrieben und/oder ausgelesen werden können. Eine Datenübertragung ist aber auch berührungslos über ein in der Karte vorgesehenes induktives Antennenelement möglich. Darüber hinaus sind Chipkarten bekannt, die sowohl Kontaktstellen zur kontaktbehafteten Datenübertragung als auch ein oder mehrere Antennenelemente zur kontaktfreien Datenübertragung aufweisen.

Bei der kontaktfreien Datenübertragung mittels eines induktiven Elements muß eine ausreichende magnetische Flußdichte im Antennenelement gewährleistet sein, damit ausreichend auflösbare Signale ausgesandt, bzw. empfangen werden können.

Die magnetische Flußdichte kann durch Erhöhen des Erregerstroms oder durch Erhöhen der Windungszahl eines Antennenelements verstärkt werden. Beidem sind in der Praxis jedoch Grenzen gesetzt.

Aus der DE 195 13 607 A1 ist eine Chipkarte bekannt, die einen integrierten Schaltkreis und ein Antennenelement zum berührungslosen Übertragen von Daten aufweist. Die Antenne weist einen Magnetkern auf, der aus einem Band einer amorphen Legierung oder einer nanokristallinen Legierung besteht und damit eine induktionssteigernde Wirkung besitzt. Auch kann das dortige Antennenelement aus mehreren planparallelen Schichten aus gleichem oder unterschiedlichem Material als Mehrschichtfolie oder Mehrschichtkörper ausgebildet sein, wobei letzterer aus mehreren miteinander verbundenen amorphen Metallfolien besteht.

Die europäische Patentanmeldung 0 554 581 A1 zeigt ein Verfahren zur Herstellung eines flachen flexiblen Antennenkerns für einen Transponderchip, wobei auch dort auf eine Schichtstruktur, die eine große relative Permeabilität aufweist, aufmerksam gemacht wird.

Bei der Chipkarte nach DE 195 00 925 A1 ist zur kontaktlosen Datenübertragung ein separat in den Kartenkörper eingebautes Übertragungsmodul vorhanden. Dieses Modul weist eine Antenne in Form mindestens einer Spule zur induktiven Daten- und Energieübertragung und/oder in Form elektrisch leitender Schichten zur kapazitiven Daten- und Energieübertragung auf. Zur elektrischen Ankopplung besitzt das Übertragungsmodul Anschlußflächen, die der Verbindung mit einem separat gefertigten Chipmodul dienen.

Aus dem Vorgenannten ist es daher Aufgabe der Erfindung, eine Chipkarte sowie ein Verfahren zum Herstellen einer Chipkarte anzugeben, welche bzw. welches die Funktionsfähigkeit der Chipkarte für die kontaktlose Datenübertragung verbessert, so daß größere Abstände zwischen Chipkarte und Leseterminal realisierbar sind, wobei gleichzeitig eine einfache und kostengünstige Herstellung zu gewährleisten ist.

Die Lösung der Aufgabe der Erfindung erfolgt mit einer Chipkarte gemäß den Merkmalen des Patentanspruchs 1 sowie einem Herstellungsverfahren gemäß Patentanspruch 13.

Vorteilhafte Weiterbildungen sind in Unteransprüchen angegeben.

Bei der Erfindung wird davon ausgegangen, ein an sich bekanntes induktionssteigerndes Element vorzusehen, dessen relative Permeabilität $\mu_r > 1$ ist und das mit dem Antennenelement zusammenwirkt.

Allgemein gilt:

$$B = \mu_r \cdot H$$

wobei H die magnetische Feldstärke bezeichnet, $\mu_r$ die relative Permeabilität und B die magnetische Flußdichte ist. Im Fall einer Spule der Länge l mit n Windungen ergibt sich

$$B = \mu_r \cdot \mu_o \cdot I_{err} \cdot \frac{n}{l} \qquad (1)$$

Nach dem Faraday Induktionsgesetz wird in einer Spule eine Spannung induziert, wenn sich der magnetische Fluß $\phi = B \cdot A_s$, der die Spule mit n Windungen mit einer Querschnittsfläche $A_s$ durchsetzt, in einer Zeitspanne $\Delta t$ um $\Delta\phi$ ändert. Es gilt:

$$U_{ind} = n \cdot \phi \qquad (2)$$

$$= n \cdot (B \cdot A_s) \cdot$$

$$= n \cdot (B \cdot A_s + B \cdot A_s)$$

$$= n \cdot B \cdot A_s + n \cdot B \cdot A_s \qquad (3)$$

Die induzierte Gesamtspannung ist demnach die Summe der induzierten Spannungen, hervorgerufen durch die Änderung der durchsetzten Querschnittsfläche $A_s$ bei konstanter magnetischer Flußdichte und durch die Änderung der magnetischen Flußdichte B bei konstanter Querschnittsfläche. Durch Einsetzen der Formel (1) in Formel (3) ergibt sich

$$U_{ind} = \mu_r \cdot \mu_0 \cdot \frac{n^2}{l} (I_{err} \cdot A_s \cdot I_{err} \cdot A_s)$$

Zur Erzielung hoher induzierter Spannungen bei hohen Frequenzen eignen sich weichmagnetische Materialen besonders gut. Weichmagnetische Materialen zeichnen sich durch eine hohe relative Permeabilität, niedrige Koerzitivkraft und einfach Ummagnetisierbarkeit aus. Die eingeschlossene Fläche in der Hysterese-Kurve dieser Materialen ist klein und damit auch die in Form von Wärme auftretenden Energieverluste.

Bei hohen Frequenzen wird allerdings die magnetische Permeabilität durch induzierte Wirbelströme reduziert. Der Durchtritt des Magnetfeldes durch das Material ist in diesem Fall behindert. Abhilfe kann hier durch Verringerung der Materialdicke und Erhöhung des elektrischen Widerstandes geschaffen werden. Technisch sind elektrisch voneinander isolierte Mehrlagenschichten aus Metallen und Legierungen mit Folienstärken von 1 mm bis 0,025 mm bereits herstellbar. Eine weitere Verbesserung kann durch Metall-/Metalloxidpulver in einem Dielektrikum erreicht werden. Die Partikelgrößen liegen dabei im Bereich von 2 bis 10 μm. Als Metalle kommen insbesondere Fe, Cu, Mn, Zn und Ni in Betracht. Die Metalle werden auch als Oxide mit Eisenoxid eingesetzt. Die generelle Formel dieser Ferrite lautet

$$MO \cdot Fe_2O_3,$$

wobei M ein beliebiges Metall aus der Gruppe Fe, Cu, Mn, Zn und Ni bezeichnet. Nachteilig ist die hohe Bruchempfindlichkeit dieser keramischen Materialien.

Der Nachteil keramischer Materialien wird durch amorphes Metall (metallische Gläser) überwunden, ohne andere Einschränkungen hinnehmen zu müssen.

In einer Weiterbildung besteht das vorgeschlagene induktive Element daher zumindest teilweise aus amorphem Metall (metallischem Glas). Amorphe Metalle zeichnen sich dadurch aus, daß die Atome in einem weitgehend ungeordneten Zustand erstarrt sind. Während normalerweise die Atome beim Abkühlen aus einer Schmelze genügend Zeit haben, Kristallkeime auszubilden und sich im Einklang mit diesen Kristallkeimen auszurichten, werden amorphe Metalle durch blitzartige Abkühlung der Schmelze, beispielsweise mit einer Abkühlungsrate von einer Million Grad pro Sekunde, erhalten.

Amorphe Metalle zeichnen sich durch mehrere günstige Eigenschaften aus. Sie sind hart, korrosionsbeständig, haben einen hohen elektrischen Widerstand und verhalten sich magnetisch weich, das heißt, sie weisen - wie bereits oben erläutert - nur eine sehr kleine Hysterese auf. Dadurch sind die Verlustleistungen gering. Es wird wenig Verlustwärme erzeugt und es treten praktisch keine Wirbelströme auf.

Durch diese kleine Hysterese und den hohen elektrischen Widerstand sind sie als induktionsverstärkende Materialien auch bei hohen Frequenzen bestens geeignet.

Die mechanischen Eigenschaften (Härte, Bruchunempfindlichkeit) sind für den Aufbau einer Chipkarte sehr vorteilhaft.

Insbesondere schnell erstarrte Cobalt-Legierungen weisen sehr günstige magnetisch, elektrische und mechanische Eigenschaften auf und sind als Bänder mit Breiten bis 20 mm bei einer Dicke von 50 μm herstellbar.

Den äußeren Abmessungen einer Chipkarte entsprechend und unter Berücksichtigung der meist sehr flachen, relativ ausgedehnten Antennenelemente ist es von Vorteil, das induktionssteigernde Element folien- oder plattenförmig auszubilden.

Weiterhin kann es von Vorteil sein, das induktionssteigernde Element als Mehrschichtkörper auszubilden. Der Mehrschichtkörper ist dabei aus mehreren planparallelen Schichten aus gleichem oder unterschiedlichem Material aufgebaut. Durch den schichtweisen Aufbau läßt sich die Dicke des induktionssteigernden Elementes vergrößern. Auch läßt sich der elektrische Widerstand senkrecht zu den Schichtebenen weiter erhöhen.

Darüber hinaus wird die mechanische Steifigkeit noch weiter verbessert. Durch die Variation unterschiedlicher Materialien läßt sich das magnetische, elektrische und/oder mechanische Verhalten durch Auswahl der Materialien und Schichtdicken einstellen.

In einer vorteilhaften Ausgestaltung bestehen die Schichten jeweils aus Folien aus amorphem Metall.

Erfindungsgemäß weist die Chipkarte einen Modulträger auf, der zur unmittelbaren oder mittelbaren Befestigung des integrierten Schaltkreises und vorzugsweise auch zur Befestigung des Antennenelements dient. Dieser Modulträger bildet praktisch den Kartenträger. Nach Befestigung der Komponenten (integrierter Schaltkreis, etc..) auf dem Modulträger werden diese eingegossen, einlaminiert oder auf andere Weise unter Ausbildung einer Chipkarte eingekapselt.

Bei einer Einbauposition des induktionssteigernden Elements ist der integrierte Schaltkreis auf einer ersten Flachseite des Modulträgers angeordnet, hingegen befindet sich das induktionssteigernde Element auf der gegenüberliegenden Flachseite des vorzugsweise plattenförmigen Modulträgers. Das induktionssteigernde Element kann mit dem Modulträger beispielsweise verklebt sein. Die Plattenstärke des Modulträgers kann reduziert werden, da das induktionssteigernde Element einen beachtlichen Beitrag zur mechanischen Steifigkeit der Gesamtanordnung liefert.

Grundsätzlich kann das Antennenelement relativ zum induktionssteigernden Element und zur integrierten Schaltung nahezu beliebig angeordnet sein. Bevorzugt wird jedoch das Antennenelement, insbesondere eine geätzte Spule, im wesentlichen konzentrisch um den integrierten Schaltkreis herum auf der dem integriertem Schaltkreis zugewandten Flachseite des Modulträgers bzw. des induktionssteigernden Elementes durch einen Ätzvorgang ausgebildet. Alternativ dazu kann das Antennenelement, insbesondere Spule auch als diskrete Drahtspule oder als gestanzte oder gedruckte Spule ausgebildet sein. Bei einer gedruckten Spule sind Polymerspule und gedruckte galvanisierte Spule zu unterscheiden. Eine Polymerspule läßt sich auch in Form einer "dispensed polymer coil" ausbilden.

Zum Verbinden des integrierten Schaltkreises mit dem Antennenelement, insbesondere der Spule bieten sich eine Vielzahl von Verbindungstechniken an. Zunächst kann der integrierte Schaltkreis als Ploymer-Flip-Chip, als Lot-Flip-Chip, als Chip-On-Board (Wire Bond) oder als Backbonded-Chip auf dem Modulträger bzw. dem induktionssteigernden Element angeordnet werden.

Bei Vorliegen eines Polymer-Flip-Chips bietet sich grundsätzlich eine elektrisch leitfähige Klebeverbindung an. Gerade bei Anschluß an eine diskrete Drahtspule kann aber auch das direkte Heranführen und Kontaktieren mittels Thermocompression Bonding oder Thermosonic Bonding sinnvoll sein.

Liegt der integrierte Schaltkreis in Form eines Löt-Flip-Chips vor, kann eine elektrisch leitfähige Verbindung durch Löten, zur Antenne oder zu einem Zwischenträger, erreicht werden. Dabei sollte sowohl auf den Löt-Flip-Chip als auch auf das Antennenelement zuvor ein gewisses Lötdepot aufgebracht werden. Alternativ dazu kann aber auch eine Schweißverbindung ausgebildet werden.

Bei der Chip-On-Board-Alternative kann eine elektrische Kontaktierung durch Draht, Bänder, metallisierte Folie oder ein metallisiertes Stanzteil erfolger.

Wird der integrierte Schaltkreis als Backbonded-Chip auf dem Modulträger bzw. dem induktionssteigernden Element angeordnet und weist er diskrete Drahtanschlüsse auf, so können diese mit dem Antennenelement durch elektrisch isotropes oder anisotropes leitfähiges Kleben, durch elektrisch leitfähige Lötung oder durch Bonden verbunden werden.

Aus dem oben genannten liegt der Kerngedanke des erfindungsgemäßen Verfahrens zur Herstellung einer Chipkarte darin, den Modulträger aus einem induktionssteigernden Element auszubilden oder den Modulträger zumindest durch ein induktionssteigerndes Element zu versteifen.

Dadurch läßt sich die magnetische Flußdichte erhöhen und somit die Signalübertragung zwischen der Karte und einer externen Lese-/Schreibstation verbessern. Darüber hinaus kann der bislang notwendige Modulträger dünner ausgebildet oder auf diesen ganz verzichtet werden. Das induktionssteigernde Element kann nämlich gleichzeitig die mechanische Funktion des Modulträgers ganz oder teilweise übernehmen. Als Modulträger besonders geeignet erscheint auch hier amorphes Metall.

Die Erfindung wird nachstehend auch hinsichtlich weiterer Merkmale und Vorteile anhand der Beschreibung eines Ausführungsbeispiels und unter Bezugnahme auf die beiliegenden Zeichnungen näher erläutert.

Hier zeigen:

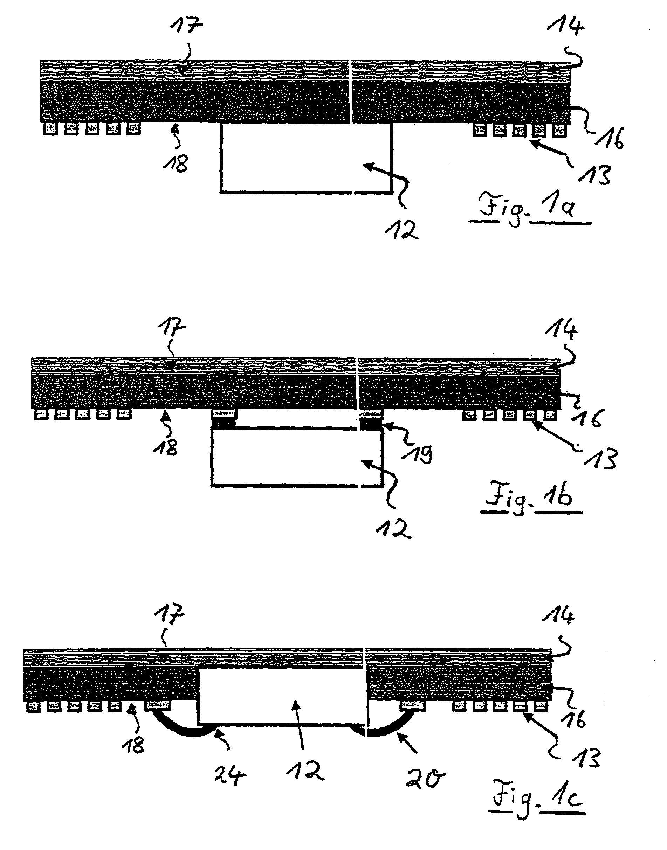

Fig. 1a schematisch eine Einbauposition für ein induktionssteigerndes Element; und

Fig. 1b und 1c unterschiedliche Verbindungstechniken für ein nach Fig. 1 a positioniertes induktionssteigerndes Element.

Bei der nachfolgenden Beschreibung werden für gleiche und gleichwirkende Bauteile diesselben Bezugsziffern verwendet. An dieser Stelle wird weiterhin darauf hingewiesen, daß die in den Zeichnungen dargestellten Größenverhältnisse nicht den tatsächlichen Gegebenheiten entsprechen, sondern die Zeichnungen als schematische Darstellungen anzusehen sind.

In Figur 1 a ist eine Einbauposition eines induktionssteigernden Elements 14 bei einer Chipkarte rein schematisch dargestellt.

Der Modulträger 16 kann zusammen mit einem integrierten Schaltkreis 12, einem Antennenelement 13 und dem induktionssteigernden Element 14 in eine vorzugsweise vorgefräste Ausnehmung eines nicht dargestellten Kartenträgers eingesetzt werden. Die Erfindung läßt sich auch auf einen Kartentyp anwenden, bei dem der Modulträger 16 sich im wesentlichen über die Gesamtabmessung einer Chipkarte erstreckt. Der integrierte Schaltkreis 12 und gegebenenfalls das Antennenelement 13 werden dann in an sich bekannter Weise eingekapselt. Es kann beispielsweise auf den sich im wesentlichen über die gesamte Karte erstreckenden Modulträger 16 ein weiterer Kartenträger auflaminiert werden, wobei der integrierte Schaltkreis 12 zwischen dem Modulträger 16 und dem weiterem Kartenträger eingebettet wird.

In der gezeigten Einbauposition ist das induktionssteigernde Element 14 auf einer ersten Flachseite 17 eines Modulträgers 16 angeordnet. Der Modulträger 16 kann dabei auf geeignete Weise mit dem induktionssteigernden Element verbunden, beispielsweise verklebt sein.

Auf der dem induktionssteigernder. Element 14 abgewandten Flachseite 18 des Modulträgers ist ein integrierter Schaltkreis 12 angeordnet. Auf dieser Flachseite 18 ist weiterhin ein Antennenelement 13, insbesondere eine spiralförmige Spule ausgebildet.

Das Antennenelement 13, insbesondere die spiralförmige Spule kann als gedruckte Spule, nämlich als gedruckte Polymerspule oder als gedruckte und galvanisierte Spule, als diskrete Drahtspule, als geätzte Spule, als beschriebene Pasten-Spule oder als gestanzte Spule ("punched coil") ausgebildet sein.

In Fig. 1 b ist eine Anschlußvariante des integrierten Schaltkreises 12 an das Antennenelement 13 dargestellt. Der integrierte Schaltkreis 12 ist hier durch elektrisch leitfähige Klebeverbindungen 19 an das Antennenelement 13 angeschlossen. Hierbei kann es sich um eine anisotrope, isotrope oder engspaltige elektrisch leitfähige Klebeverbindungen 19 handeln. Anstelle der Klebeverbindungen kann auch eine intermetallische Lot- oder Schweißverbindung in Betracht kommen.

Die Klebe-, Lot- oder Schweißverbindung, stellt in erster Linie eine elektrische Verbindung zum Antennenelement 13 dar. Gleichzeitig wird aber auch eine mechanische Verbindung ausgebildet. Da die spiralförmige Spule 13 in der Regel fest auf dem Modulträger 16 angeordnet ist, wird durch diese Klebe-, Lot- und Schweißverbindung gleichzeitig eine mechanische Verbindung zum Modulträger 16 geschaffen. Modulträger 16, induktionssteigerndes Element 14, spiralförmige Spule bzw. Antennenelement 13 und integrierter Schaltkreis 12 stellen somit eine Einheit dar. Diese Eirheit kann je nach Kartentyp nun in eine Ausnehmung im Kartenträger eingesetzt werden oder bereits eine Flachseite der späteren Chipkarte bilden. Selbstverständlich kann auf das folien- oder plattenförmig ausgebildete induktionssteigernde Element 14 noch eine nicht gezeigte Schutz- und/oder Lackschicht aufgebracht werden.

In Fig. 1 c sind weitere alternative Anschlußvarianten für den integrierten Schaltkreis 12 an das Antennenelement 13 schematisch dargestellt. Der integrierte Schaltkreis 12 kann hier, wie in Fig. 1 a dargestellt, auf dem Modulträger 16 angeordnet sein. Er kann aber auch in den Modulträger 16 integriert sein.

Allgemein lassen sich "Chip-On-Board"-Lösungen und "Chip-implanted-In-Board"-Lösungen unterscheiden. Der integrierte Schaltkreis 12 weist Anschlüsse 24 auf, die mit dem Antennenelement bzw. der spiralförmigen Spule 13 durch geeignete Leiter, insbesondere Bond-Verbindungen 20 elektrisch verbunden werden. Die Bondverbindungen könren in bekannter Weise durch Thermosonic-Bonding oder Thermocompression Bonding ausgebildet werden.

Zweckmäßigerweise wird der integrierte Schaltkreis 12 (vgl. Fig. 1c) so angeordnet, daß sich die Anschlüsse 24 auf seiner dem Modulträger 16 abgewandten Seite befinden. In dieser Anordnung können die Bond-Verbindungen 20 auf einfache und kostengünstige Weise hergestellt werden.

Natürlich lassen sich der integrierte Schaltkreis 12 und die spiralförmige Spule 13 auch in anderer Weise durch Leiter verbinden, beispielsweise durch Löten oder Schweißen.

Das induktionssteigernde Element 14 ist vorzugsweise aus amorphen Metall gebildet. Die amorphen Metalle sind magnetisch weich und zeichnen sich durch eine sehr geringe Hysterese aus, was einen Einsatz auch bei hohen Frequenzen ermöglicht. Darüber hinaus weisen sie einen sehr hohen spezifischen Widerstand auf, so daß sich keine nennenswerten Wirbelströme ausbilden können. Besonders bevorzugt werden amorphe Metalle auf der Basis von Co-Legierungen verwendet. Sie sind als Bänder mit Breiten bis 20 mm bei einer Dicke von 15 μm ohne weiteres herstell- und in eine Chipkarte einsetzbar. Das induktionssteigernde Element 14 läßt sich in diesem Fall auch aus mehreren nebeneinander und übereinander angeordneten Bändern herstellen.

Wenn eine Chipkarte mit einem induktionssteigernden Element versehen wird, werden zur Signalübertragung weniger starke Erregerströme benötigt. Durch die erhöhte magnetische Flußdichte lassen sich die Signale in Sende- und Empfangsbetrieb der Chipkarte verstärken.

Die zuvor beschriebenen Einbaumöglichkeiten für ein induktionssteigerndes Element, das insbesondere aus amorphem Metall gebildet ist, sind rein beispielhaft. Es lassen sich auch andere Einbaupositionen und Geometrien für das induktionssteigernde Element ausbilden ohne den Rahmen der Erfindung zu verlassen.

Bezugszeichenliste

| | |
|---|---|
| 12 | integrierter Schaltkreis |
| 13 | Antennenelement, spiralförmige Spule |
| 14 | induktionssteigerndes Element |
| 15 | Mehrschichtkörper |
| 16 | Modulträger |
| 17 | eine Flachseite (Modulträger) |
| 18 | andere Flachseite (Modulträger) |
| 19 | Klebeverbindung |
| 20 | Leiter, Bondverbindungen |
| 21, 22 | Schichten |
| 23 | Flachseite (induktionssteigerndes Element) |
| 24 | Anschlüsse |

**Patentansprüche**

**1.** Chipkarte, die einen integrierten Schaltkreis (12) und ein Antennenelement (13) zum berührungslosen Übertragen von Daten aufweist, wobei das Antennenelement (13) mit einem induktionssteigernden Element (14) mit einer relativen Permeabilität $\mu_r > 1$ zusammenwirkt **dadurch gekennzeichnet,** **daß** die Chipkarte weiterhin einen Modulträger (16) aufweist, wobei der Modulträger (16) auf einer Flachseite (17) mit dem induktionssteigernden Element (14) versehen ist und auf der gegenüberliegenden Flachseite (18) des Modulträgers (16) der integrierte Schaltkreis (12) angeordnet ist.

**2.** Chipkarte nach Anspruch 1, **dadurch gekennzeichnet ,** **daß** das Antennenelement (13) zumindest teilweise aus amorphem Metall (metallischem Glas) besteht.

**3.** Chipkarte nach Anspruch 2, **dadurch gekennzeichnet,** **daß** das amorphe Metall Korngrößen < 10 μm und einen hohen elektrischen Widerstand aufweist.

4. Chipkarte nach Anspruch 2 oder 3,
**dadurch gekennzeichnet,**
**daß** das amorphe Metall aus einer schnell erstarrten Cobalt-Legierung gebildet ist.

5. Chipkarte nach einem der Ansprüche 1 bis 4,
**dadurch gekennzeichnet,**
**daß** das Antennenelement (13) platten- oder folienförmig ausgebildet ist.

6. Chipkarte nach einem der Ansprüche 1 bis 5,
**dadurch gekennzeichnet,**
**daß** das Antennenelement (13) aus mehreren planparallelen Schichten (21, 22) aus gleichem oder unterschiedlichem Material als Mehrschichtfolie oder Mehrschichtkörper (15) ausgebildet ist.

7. Chipkarte nach Anspruch 6,
**dadurch gekennzeichnet,**
**daß** der Mehrschichtkörper (15) aus mehreren miteinander verbundenen, insbesondere verklebten amorphen Metallfolien besteht.

8. Chipkarte nach Anspruch 7,
**dadurch gekennzeichnet,**
**daß** die Folienstärke der Metallfolien im Bereich zwischen 1 mm und 0,025 mm liegt.

9. Chipkarte nach einem der vorangegangenen Ansprüche,
**dadurch gekennzeichnet,**
**daß** das Antennenelement (13) auf der dem integrierten Schaltkreis (12) zugewandten Flachseite (18) des Modulträgers (16), vorzugsweise im wesentlichen konzentrisch um den integrierten Schaltkreis (12) herum angeordnet ist.

10. Chipkarte nach einem der Ansprüche 1 bis 9,
**dadurch gekennzeichnet,**
**daß** das Antennenelement (13), insbesondere eine, Drahtspule, eine geätzte oder gedruckte Spule oder eine dispersierte Polymerspule durch eine isotrope oder anisotrope, elektrisch leitfähige Klebe-, Schweiß- oder Lötverbindung (19) mit dem integrierten Schaltkreis (12) verbunden ist (Polymer Flip-Chip, bzw. Lot-Flip-Chip).

11. Chipkarte nach einem der Ansprüche 1 bis 12,
**dadurch gekennzeichnet,**
**daß** das Antennenelement (13) und der integrierte Schaltkreis (12) durch direkte Kontaktierung, insbesondere durch entsprechende Drähte, Drahtbänder, metallisierte Folie, oder metallisierte Stanzteile miteinander verbunden sind (Chip on Board; Wire Bond).

12. Chipkarte nach einem der Ansprüche 1 bis 9,
**dadurch gekennzeichnet,**
**daß** das Antennenelement (13) durch direktes Heranführen und Kontaktieren einer Mehrzahl von Drähten (20) in einem Bond-Verfahren, insbesondere einem Thermosonic-Bond-Verfahren mit Anschlüssen (24) auf der dem Modulträger (16) bzw. den induktionssteigernden Element (14) abgewandten Seite des integrierten Schaltkreises (12) mit dem integrierten Schaltkreis (12) verbunden ist.

13. Verfahren zur Herstellung einer Chipkarte, wobei ein auf einem Modulträger (16) befindlicher elektrischer Schaltkreis (12) in einer Ausnehmung eines Kartenträgers (11) unter Erhalt einer elektrischen und mechanischen Verbindung eingesetzt wird, oder sich der Modulträger im wesentlichen über die gesamte Chipkarte erstreckt und in diese einlaminiert wird, und der Modulträger (16) aus einem an sich bekannten induktionssteigernden Element (14) gebildet wird oder der Modulträger (16) zumindest durch ein solches bekanntes induktionssteigerndes Element (14) mechanisch versteift wird.

## Claims

1. A chip card which comprises an integrated circuit (12) and an antenna element (13) for the contact-free transmission of data, with the antenna element (13) cooperating with an induction increasing element (14) with a relative permeability $\mu_r > 1$,
**characterised in that**
the chip card further comprises a module carrier (16), with the module carrier (16) being provided with the induction increasing element (14) on one flat side and the integrated circuit (12) is arranged on the opposite flat side (18) of the module carrier (16).

2. The chip card according to Claim 1,
**characterised in that**
the antenna element (13) consists at least partially of an amorphous metal (metallic glass).

3. The chip card according to Claim 2,
**characterised in that**
the amorphous metal comprises grain sizes < 10 $\mu$m and a high electrical resistance.

4. The chip card according to Claim 2 or 3,
**characterised in that**
the amorphous metal is formed from a rapidly solidifying cobalt alloy.

5. The chip card according to one of Claims 1 to 4,
**characterised in that**
the antenna element (13) is formed plate- or foil-shaped.

**6.** The chip card according to one of Claims 1 to 5, **characterised in that** the antenna element (13) is formed from several coplanar layers (21, 22) of the same or different materials as a multilayer foil or multilayer body (15).

**7.** The chip card according to Claim 6, **characterised in that** the multilayer body (15) consists of several joined, in particular bonded, amorphous metal foils.

**8.** The chip card according to Claim 7, **characterised in that** the foil thickness of the metal foils ranges between 1 mm and 0.025 mm.

**9.** The chip card according to one of the previous claims, **characterised in that** the antenna element (13) is arranged on the flat side (18) of the module carrier (16), which faces towards the integrated circuit (16), preferably essentially concentrically about the integrated circuit (12).

**10.** The chip card according to one of Claims 1 to 9, **characterised in that** the antenna element (13), in particular a wire coil, an etched or printed coil, or a dispersed polymer coil is joined with the integrated circuit (12) by an isotropic or anisotropic electrically conductive adhesive, weld, or solder joint (19) (polymer flip chip or solder flip chip, respectively).

**11.** The chip card according to one of Claims 1 to 9, **characterised in that** the antenna element (13) and the integrated circuit (12) are connected with each other by direct contacting, in particular by corresponding wires, wire bands, metallised foil, or metallised punched parts (chip on board; wire bond).

**12.** The chip card according to one of Claims 1 to 9, **characterised in that** the antenna element (13) is connected with the integrated circuit (12) by the direct routing and contacting of a plurality of wires (20) in a bond method, in particular in a thermosonic bond process, with connections (24) on the module carrier (16) or the side of the integrated circuit (12) facing away from the induction increasing element (14), respectively.

**13.** A method for the manufacture of a chip card, wherein an electric circuit (12) being disposed on a module carrier (16) is inserted into a recess of a card carrier (11) under obtaining an electrical or mechanical connection, or the module carrier extends essentially over the entire chip card and is laminated into same,

and the module carrier (16) is formed from an induction increasing element known as such, or the module carrier (16) is at least mechanically reinforced by such a known induction increasing element (14).

**Revendications**

**1.** Carte à puce, qui comprend un circuit intégré (12) et un élément d'antenne (13) pour la transmission de données sans contact, dans laquelle l'élément d'antenne (13) coopère avec un élément (14) augmentant l'induction avec une perméabilité relative $\mu_r > 1$, **caractérisée en ce que** la carte à puce comprend en outre un porte-module (16), ledit porte-module (16) étant doté de l'élément augmentant l'induction (14) sur un côté plat (17), et **en ce que** le circuit intégré (12) est agencé sur le côté plat opposé (18) du porte-module (16).

**2.** Carte à puce selon la revendication 1, **caractérisée en ce que** l'élément d'antenne (13) est réalisé au moins partiellement en métal amorphe (verre métallique).

**3.** Carte à puce selon la revendication 2, **caractérisée en ce que** le métal amorphe présente des particules de taille < 10 microns et une résistance électrique élevée.

**4.** Carte à puce de selon l'une ou l'autre des revendications 2 et 3, **caractérisée en ce que** le métal amorphe est formé par un alliage au cobalt rapidement solidifié.

**5.** Carte à puce selon l'une des revendications 1 à 4, **caractérisée en ce que** l'élément d'antenne (13) est réalisé sous forme de plaquette ou de feuille.

**6.** Carte à puce selon l'une des revendications 1 à 5, **caractérisée en ce que** l'élément d'antenne (13) est formé par plusieurs couches à plans parallèles (21, 22) du même matériau ou de matériaux différents, sous forme d'une feuille ou d'un corps multicouche (15).

**7.** Carte à puce selon la revendication 6, **caractérisée en ce que** le corps multicouche (15) est constitué de plusieurs feuilles métalliques amorphes reliées les unes aux autres et en particulier collées.

**8.** Carte à puce selon la revendication 7, **caractérisée en ce que** l'épaisseur des feuilles métalliques est comprise dans la plage entre 1 mm et 0,025 mm.

**9.** Carte à puce selon l'une des revendications précédentes, **caractérisée en ce que** l'élément d'antenne (13) est agencé sur le côté plat (18) du porte-module (16) tourné vers le circuit intégré (12), et de préférence agencé sensiblement concentriquement autour du circuit intégré (12).

10. Carte à puce selon l'une des revendications 1 à 9, **caractérisée en ce que** l'élément d'antenne (13), en particulier une bobine en fil, une bobine réalisée par attaque chimique ou par impression, ou une bobine en polymère dispersé, est relié au circuit intégré (12) par une jonction collée, soudée ou brasée (19) isotrope ou anisotrope et capable de conduire l'électricité (puce du type "Flip-Chip" au polymère, ou à la brasure).

11. Carte à puce selon l'une des revendications 1 à 12, **caractérisée en ce que** l'élément d'antenne (13) et le circuit intégré (12) sont reliés l'un à l'autre par mise en contact direct, en particulier au moyen de fils, de rubans, de film métallisé, ou de parties estampées métallisées correspondantes (puce sur carte ; jonction par fil).

12. Carte à puce selon l'une des revendications 1 à 9, **caractérisée en ce que** l'élément d'antenne (13) est relié au circuit intégré (12) par approche directe et mise en contact d'une pluralité de fils (20), dans un procédé par adhésion, en particulier par un procédé par adhésion thermo-sonique avec des bornes (24) sur le côté du circuit intégré (12) détourné du porte-module (16), respectivement de l'élément augmentant l'induction (14).

13. Procédé pour réaliser une carte à puce, dans lequel un circuit électrique (12) disposé sur porte-module (16) est mis en place dans un évidement d'un porte-carte (11) en établissant une liaison électrique et mécanique, ou en ce que le porte-module s'étend sensiblement sur la totalité de la carte à puce et intégré dans celle-ci par laminage, et le porte-module (16) est réalisé par un élément (14) connu en lui-même et augmentant l'induction, ou en ce que le porte-module (16) est au moins rigidifié sur le plan mécanique par un tel élément connu (14) augmentant l'induction.

17

14

18

16

13

_Fig. 1a_

12

17

14

18

16

19

13

_Fig. 1b_

12

17

14

18

16

13

24

12

20

_Fig. 1c_